(19) Europäisches Patentamt
European Patent Office
Office européen des brevets

(11) **EP 3 926 426 A1**

(12) **EUROPEAN PATENT APPLICATION**

(43) Date of publication:
**22.12.2021 Bulletin 2021/51**

(51) Int Cl.:
**G05B 19/418** (2006.01)     **G05B 13/04** (2006.01)
**H02K 11/25** (2016.01)     **H02H 7/085** (2006.01)

(21) Application number: **20180009.1**

(22) Date of filing: **15.06.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventors:
• KAKOSIMOS, Panagiotis
 723 58 Västerås (SE)
• BERTOLDI, Frederico
 5415 Aargau (CH)
• CHEN, Wenliang
 722 33 Västerås (SE)
• RÖNNBERG, Kristian
 723 40 Västerås (SE)

(74) Representative: **Kransell & Wennborg KB**
**P.O. Box 27834**
**115 93 Stockholm (SE)**

(54) **METHOD OF MONITORING AN ELECTRICAL MACHINE**

(57)     A method of monitoring an electrical machine, wherein the method comprises: a) obtaining temperature measurement values of the temperature at a plurality of locations of the electrical machine, b) obtaining estimated temperatures at said plurality of locations given by a thermal model of the electrical machine, the thermal model comprising initial weight parameter values, c) minimizing a difference between the temperature measurement values and the estimated temperatures by finding optimal weight parameter values, d) storing the initial weight parameter values to thereby obtain a storage of used weight parameter values, and updating the optimal weight parameter values as new initial weight parameter values, and repeating steps a)-d) over and over during operation of the electrical machine.

Fig. 3

**Description**

**TECHNICAL FIELD**

The present disclosure generally relates to electrical machines.

**BACKGROUND**

Thermal models are used to predict the temperature distribution in electrical machines. Several thermal modelling approaches are currently in use for estimating the temperature distribution. These include finite element and computational fluid dynamics thermal models and lumped-parameter thermal network (LPTN) models. LPTN models are preferable due to the inherent simplicity and fast calculation times.

In an LPTN, the distribution of the heat flow and temperature in the electrical machine is estimated by using an equivalent circuit which comprises thermal resistances, thermal capacitances and heat sources. The geometry and material properties are used to derive the thermal parameters in the design phase.

The publication "Analytical Thermal Model for Fast Stator Winding Temperature Prediction", Sciascera et al., IEEE Transactions on industrial electronics, Vol. 64, No. 8, August 2017, discloses a thermal modelling technique which predicts the winding temperature of electrical machines. A seven-node thermal model is first implemented. An empirical procedure to fine-tune the critical parameters of the model due to uncertainties in material properties, manufacturing tolerances, assembly process, and interaction with other drive system components is disclosed. The tuning procedure involves 1) experimental acquisition of winding temperature profiles, 2) definition of an objective function representing the error between LPTN predictions and experimental profiles, and 3) finding a set of optimal correction factors which minimises the objective function. A simplification of the seven-node thermal network with an equivalent three-node network is then implemented.

**SUMMARY**

The present inventors have found that expected estimated temperatures significantly differ from those measured in the field. The accuracy of the analytical model is unquestionable because several tests are conducted during the development and validation stages. Nevertheless, its simplified nature dictates that equivalent circuit parameters are used for representing the thermal distribution. Some parameters are defined solely by geometry and material properties and remain constant through the machine life although the operating conditions change. Other parameters change throughout the life of the machine due to wear or the ambient conditions the machine is exposed to. The inaccurate heat flow and temperature estimation is attributed to the neglection of the non-static nature of the parameters of the analytical model.

In view of the above, a general object of the present disclosure is to provide a method of monitoring an electrical machine which solves or at least mitigates the problems of the prior art.

There is hence according to a first aspect of the present disclosure provided a method of monitoring an electrical machine, wherein the method comprises: a) obtaining temperature measurement values of the temperature at a plurality of locations of the electrical machine, b) obtaining estimated temperatures at said plurality of locations given by a thermal model of the electrical machine, the thermal model comprising initial weight parameter values, c) minimizing a difference between the temperature measurement values and the estimated temperatures by finding optimal weight parameter values, d) storing the initial weight parameter values to thereby obtain a storage of used weight parameter values, and updating the optimal weight parameter values as new initial weight parameter values, and repeating steps a)-d) over and over during operation of the electrical machine.

The thermal model is thereby updated to stay close to the actual thermal characteristics of the electrical machine over time. Temperature estimation may thereby be made more precise over the lifetime of the electrical machine.

The electrical machine may be a motor or a generator.

One embodiment comprises comparing the optimal weight parameter values with the initial weight parameter values or with the used weight parameter values, and detecting whether a change in electrical machine performance or an electrical machine fault has occurred based on the comparison result.

Each optimal weight parameter value is beneficially compared with the corresponding initial weight parameter value or with the corresponding used weight parameter value.

According to one embodiment the detecting involves detecting a change in electrical machine performance or an electrical machine fault in case one of the optimal weight parameter values deviates by more than a predetermined amount from its corresponding initial weight parameter value or used weight parameter value.

Electrical machine diagnostics with regards to electrical machine performance or electrical machine fault may thus be provided.

The electrical machine performance may for example be affected by material-related issues such as some degradation of the winding insulation due to thermal stress, or due to an abnormality in external components such as in the heat exchanger, due to dust piled on the electrical machine frame, or environmental changes that influence the thermal behaviour of the electrical machine.

Electrical machine faults may for example be material-related faults, such as the breakdown of the winding insulation leading to turn-to-turn short circuits in the rotor or stator windings.

One embodiment comprises determining a reason for the change in electrical machine performance or electrical machine fault based on the deviating optimal weight parameter value.

The weight parameter values, i.e. the initial weight parameter values, the used weight parameter values, and the optimal weight parameter values, are constants of the equation system that forms the thermal model and describes the thermal behaviour of the electrical machine. By detecting which one of the constants is deviating, the corresponding thermal impedance or power loss injection position may be determined and thus the type and location of the fault.

According to one embodiment the weight parameter values are arranged in subsets forming respective correction matrices. With "weight parameter values" is here meant any one of the optimal weight parameter values, the initial weight parameter values, or used weight parameter values.

According to one embodiment the thermal model is a matrix equation including a thermal capacitance matrix, a thermal resistance matrix, and a power loss injection vector, wherein each of the thermal capacitance matrix, the thermal resistance matrix, and the power loss injection vector is multiplied with a respective one of the correction matrices.

According to one embodiment the thermal model is a lumped-parameter thermal network, LPTN, model.

There is according to a second aspect of the present disclosure provided a computer program comprising computer code which when executed by processing circuitry of a monitoring device causes the monitoring device to perform the method of the first aspect.

There is according to a third aspect of the present disclosure provided a monitoring device for monitoring an electrical machine, the monitoring device comprises: a storage medium comprising computer code, and processing circuitry, wherein when the processing circuitry executes the computer code, the monitoring device is configured to: a) obtain temperature measurement values of the temperature at a plurality of locations of the electrical machine, b) obtain estimated temperatures at said plurality of locations given by a thermal model of the electrical machine, the thermal model comprising initial weight parameter values, c) minimize a difference between the temperature measurement values and the estimated temperatures by finding optimal weight parameter values, d) store the initial weight parameter values to thereby obtain a storage of used weight parameter values, and updating the optimal weight parameter values as new initial weight parameter values, and repeat steps a)-d) over and over during operation of the electrical machine.

According to one embodiment the processing circuitry is compare the optimal weight parameter values with the initial weight parameter values or with the used weight parameter values, and to detect whether a change in electrical machine performance or an electrical machine fault has occurred based on the comparison result.

According to one embodiment the detecting involves detecting a change in electrical machine performance or an electrical machine fault in case one of the optimal weight parameter values deviates by more than a predetermined amount from its corresponding initial weight parameter value or used weight parameter value.

According to one embodiment the processing circuitry is configured to determine a reason for the change in electrical machine performance or electrical machine fault based on the deviating optimal weight parameter value.

According to one embodiment the weight parameter values are arranged in subsets forming respective correction matrices.

According to one embodiment the thermal model is a matrix equation including a thermal capacitance matrix, a thermal resistance matrix, and a power loss injection vector, wherein each of the thermal capacitance matrix, the thermal resistance matrix, and the power loss injection vector is multiplied with a respective one of the correction matrices.

According to one embodiment the thermal model is a lumped-parameter thermal network, LPTN, model.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

**BRIEF DESCRIPTION OF THE DRAWINGS**

The specific embodiments of the inventive concept will now be described, by way of example, with reference to the accompanying drawings, in which:

Fig. 1 schematically shows an example of a monitoring device for monitoring an electrical machine;

Fig. 2 shows an example of a simplified LPTN for an electrical machine; and

Fig. 3 is a flowchart of a method of monitoring an electrical machine by means of the monitoring device in Fig. 1.

**DETAILED DESCRIPTION**

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

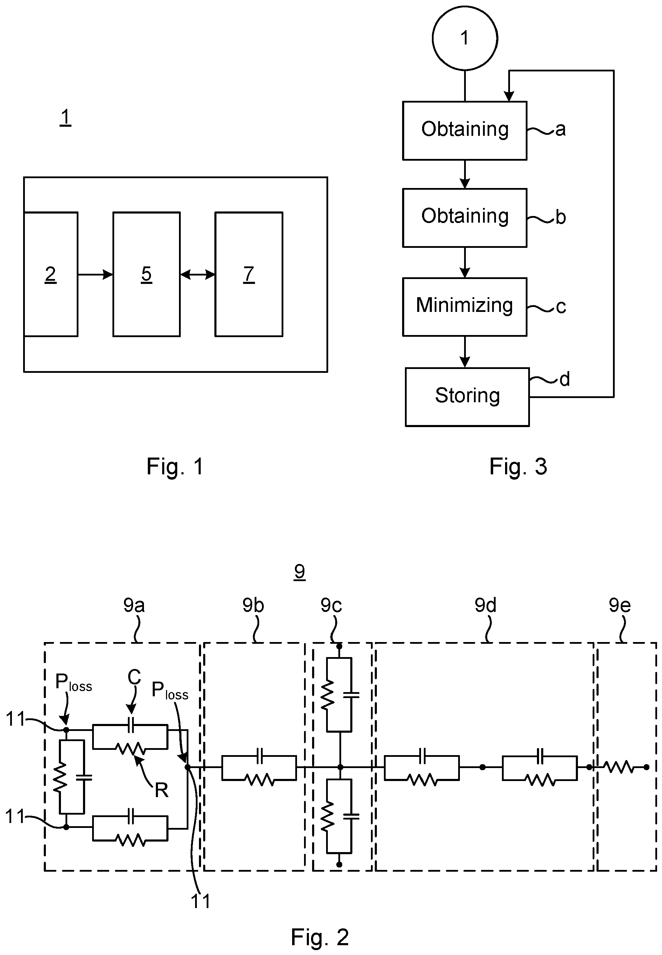

Fig. 1 depicts a block diagram of an example of a monitoring device 1. The monitoring device 1 is configured to monitor the condition and/or the performance of an electrical machine. The electrical machine may be a motor or a generator.

The electrical machine comprises a plurality of temperature sensors configured to measure the temperature in a respective one of a plurality of different locations of the electrical machine. The temperature sensors may for example be configured to detect the temperature of the stator windings, the rotor windings, the rotor surface and/or the stator chassis.

The monitoring device 1 comprises an input unit 2 configured to receive temperature measurement values from the temperature sensors. The monitoring device 1 may be configured to receive the temperature measurement values by wireless, wired, or a combination of wireless and wired communication.

The monitoring device 1 comprises processing circuitry 5 configured to receive the temperature measurement values from the input unit 2. The monitoring device 1 may comprise a storage medium 7.

The storage medium 7 may comprise a computer program including computer code which when executed by the processing circuitry 7 causes the monitoring device 1 to perform the method as disclosed herein.

The processing circuitry 5 may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning the monitoring of an electrical machine.

The method involves estimating the temperature at the plurality of locations where the temperature sensors measure the temperature by means of a thermal model of the electrical machine. The method furthermore involves minimising the difference between the estimated temperatures and the temperature measurement values by adjusting the thermal model, as will be elaborated upon in the following.

The storage medium 7 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

Fig. 2 shows an example of thermal model 9 of an electrical machine. The thermal model 9 depicted is for reasons of clarity a simplified thermal model. The thermal model 9 is an LPTN model.

The thermal model 9 models the heat flow and temperature distribution in the electrical machine. This modelling is done by an equivalent thermal circuit which comprises thermal impedances and power loss injections $P_{loss}$. Power losses appear as heat sources in a thermal model, and herein the term power loss injection and the term heat source may be used interchangeably. The thermal impedances may be thermal resistances R and thermal capacitances C.

The thermal resistances R may for example model heat dissipation by natural convection, or heat flow by conduction. The thermal capacitances C model the thermal mass of the various portions or parts of the electrical machine. The thermal capacitances C may be calculated as the product of the mass and specific heat capacity of the material of the portions or parts of the electrical machine.

The selection of the thermal resistances R and thermal capacitances C may initially in the design phase be determined based on the geometry of the electrical machine and from the properties of the materials used.

The thermal model 9 is formed by a plurality of sections. The thermal model 9 includes a rotor model section 9a, an airgap model section 9b, a tooth/stator winding model section 9c, a stator model section 9d, and an external air model section 9e.

The thermal model 9 includes a plurality of points or nodes 11. The exemplified thermal model 9 is a nine-node circuit, but could alternatively comprise a different number of nodes, depending on e.g. the type of electrical machine that is being modelled.

The thermal model 9 may be represented by a matrix equation:

$$T = \alpha R \cdot \gamma P + \beta C \cdot \frac{dT}{dt}$$

where **T** is a temperature vector describing the temperature at the nodes 11 in the LPTN and **P** is a power loss injection vector comprising the power loss injection Pioss in each node 11. **R** is a matrix representing the thermal resistances R and is thus a thermal resistance matrix. **C** is a matrix representing the thermal capacitances C and is thus a thermal capacitance matrix. $\alpha$, $\beta$, and $\gamma$ are weight parameters in the form of matrices. The weight parameters $\alpha$, $\beta$, and $\gamma$ are correction matrices. Initially, the weight parameters $\alpha$, $\beta$, and $\gamma$ may for example be identity matrices. The elements of the matrices $\alpha$, $\beta$, and $\gamma$ are herein referred to as weight parameter values. The weight parameter $\alpha$ is multiplied with the thermal resistance matrix **R,** the weight parameter $\gamma$ is multiplied with the power loss injection vector **P,** and the weight parameter $\beta$ is multiplied with the thermal capacitance matrix **C.**

With reference to Fig. 3 a method of monitoring an electrical machine by means of the monitoring device

In a step a) temperature measurement values of the temperature at a plurality of locations of the electrical machine are obtained. The temperature measurement values are obtained from the temperature sensors located on or in the electrical machine.

In a step b) estimated temperatures at the plurality of locations given by a thermal model of the electrical machine are obtained. At this point in the method, the weight parameter values of the weight parameters $\alpha$, $\beta$, and $\gamma$ are herein referred to as initial weight parameter values.

In a step c) a minimization of the difference between the estimated temperatures and the corresponding temperature measurement values is performed. The minimization involves finding optimal weight parameters $\alpha$, $\beta$, and $\gamma$ to minimise the difference between the estimated temperatures and the temperature measurement values. The elements of the matrices $\alpha$, $\beta$, and $\gamma$, i.e. the weight parameter values, may thus be varied to find the optimal weight parameter values and thus the optimal weight parameters $\alpha$, $\beta$, and $\gamma$, which minimises the difference between the estimated temperatures determined by the thermal model 9 and the temperature measurement values.

The optimisation performed in step c) may for example be performed using a standard optimisation routine such as an iterative sequential quadratic programming method or machine learning.

In a step d) the initial weight parameter values are stored to obtain a storage, or a stored set, of used weight parameter values. The initial weight parameter values may be stored in matrix form, i.e. as correction matrices. The used weight parameter values are thus the elements of used weight parameters in the form of matrices, which are initial weight parameters from previous iterations of the method. The used weight parameter values may also comprise reference weight parameter values which form part of weight parameters in the thermal model 9 that correctly described the thermal behaviour of the electrical machine at commissioning, i.e. when the electrical machine was new. The used weight parameters may in step d) be stored in the storage medium 7.

In step d) the optimal weight parameter values are updated as new initial weight parameters. The optimal weight parameter values are thus set as new initial weight parameter values.

Steps a)-d) are repeated over and over during operation of the electrical machine, e.g. during the remaining lifetime of the electrical machine. Each time that the method is performed, the previous optimal weight parameter values are the initial weight parameter values and new optimal weight parameter values, which may or may not be the same as the previous optimal weight parameter values, are determined in step c).

The thermal model 9 will thereby stay up to date with the thermal behaviour of the electrical machine and the temperature estimations will thereby be more precise over time.

The steps a)-d) may for example be repeated after a predetermined time has elapsed since the last time the method was performed.

According to one variation the optimal weight parameter values are compared with the initial weight parameter values or with the used weight parameter values. Corresponding optimal weight parameter values are compared with corresponding initial weight parameter values or corresponding used weight parameter values. Thus, the comparison may be made between elements of the optimal weight parameter matrices and corresponding elements of the corresponding initial weight parameters or corresponding elements of corresponding used weight parameters from a previous iteration of the method.

This step may for example be performed in conjunction with step c), after step c) but before step d), or after step d).

The reference weight parameters values are elements of matrices, in which each element represents a reference value associated with a healthy electrical machine modelled by the thermal model 9.

In this variation, a change in electrical machine performance or an electrical machine fault is detected in case one of the optimal weight parameter values of the optimal weight parameters $\alpha$, $\beta$, and $\gamma$ deviates by more than a predetermined amount from its corresponding weight parameter value of an initial weight parameter or used weight parameter.

According to one example a reason for the change in electrical machine performance or electrical machine fault can be determined from a deviating weight parameter value. The reason may thus be determined based on which element or weight parameter value or element is/are a deviating weight parameter value or element and/or the amount of deviation.

The method may be able to detect slow as well as fast changes of the performance of an electrical machine. For example, to detect slow changes the optimal weight parameter values may be compared with the corresponding reference weight parameter values, or with corresponding used weight parameter values stored at an early stage of the lifetime of the electrical machine. These changes may build up slowly, for example due to dust slowly piling on the electrical machine or due to crud in the heat exchanger, causing deterioration in cooling and a rise in temperature.

If it for example is determined that the thermal model has updated the element(s) of the thermal resistance matrix, i.e. the optimal weight parameter values of the thermal resistance matrix, that describes how heat is dissipated through the electrical machine frame, it may give an indication that cleaning of the electrical machine is a desired action to mitigate the elevated temperature levels.

Fast changes can be determined by comparing the optimal weight parameter values with the corresponding initial weight parameter values, or with corresponding used weight parameter values stored recently such as during the previous iteration of the method.

The predetermined time after which steps a)-c) are repeated may according to one variation be determined based on the amount that the weight parameter values of the matrices $\alpha$, $\beta$, and $\gamma$ have changed since the previous iteration of the method. For example, in case the magnitude of one or more elements has changed but less than the predetermined amount, the method may be performed more often to better keep track of any changes to the electrical machine performance or condition.

The inventive concept has mainly been described above with reference to a few examples. However, as is readily appreciated by a person skilled in the art, other embodiments than the ones disclosed above are equally possible within the scope of the inventive concept, as defined by the appended claims.

**Claims**

1. A method of monitoring an electrical machine, wherein the method comprises:

   a) obtaining temperature measurement values of the temperature at a plurality of locations of the electrical machine,
   b) obtaining estimated temperatures at said plurality of locations given by a thermal model (9) of the electrical machine, the thermal model (9) comprising initial weight parameter values,
   c) minimizing a difference between the temperature measurement values and the estimated temperatures by finding optimal weight parameter values,
   d) storing the initial weight parameter values to thereby obtain a storage of used weight parameter values, and updating the optimal weight parameter values as new initial weight parameter values, and

   repeating steps a)-d) over and over during operation of the electrical machine.

2. The method as claimed in claim 1, comprising comparing the optimal weight parameter values with the initial weight parameter values or with the used weight parameter values, and detecting whether a change in electrical machine performance or an electrical machine fault has occurred based on the comparison result.

3. The method as claimed in claim 2, wherein the detecting involves detecting a change in electrical machine performance or an electrical machine fault in case one of the optimal weight parameter values deviates by more than a predetermined amount from its corresponding initial weight parameter value or used weight parameter value.

4. The method as claimed in claim 3, comprising determining a reason for the change in electrical machine performance or electrical machine fault based on the deviating optimal weight parameter value.

5. The method as claimed in any of the preceding claims, wherein the weight parameter values are arranged in subsets forming respective correction matrices.

6. The method as claimed in claim 5, wherein the thermal model (9) is a matrix equation including a thermal capacitance matrix, a thermal resistance matrix, and a power loss injection vector, wherein each of the thermal capacitance matrix, the thermal resistance matrix, and the power loss injection vector is multiplied with a respective one of the correction matrices.

7. The method as claimed in any of the preceding claims, wherein the thermal model (9) is a lumped-parameter thermal network, LPTN, model.

8. A computer program comprising computer code which when executed by processing circuitry (5) of a monitoring device (1) causes the monitoring device (1) to perform the method as claimed in any of claims 1-7.

9. A monitoring device (1) for monitoring an electrical machine, the monitoring device (1) comprises:

   a storage medium (7) comprising computer code, and
   processing circuitry (5),
   wherein when the processing circuitry (5) executes the computer code, the monitoring device (1) is configured to:

   a) obtain temperature measurement values of the temperature at a plurality of locations of the electrical machine,
   b) obtain estimated temperatures at said plurality of locations given by a thermal model (9) of the electrical machine, the thermal model (9) comprising initial weight parameter values,
   c) minimize a difference between the temperature measurement values and the estimated temperatures by finding optimal weight parameter values,
   d) store the initial weight parameter values to thereby obtain a storage of used weight parameter values, and updating the optimal weight parameter values as new initial weight parameter values, and

repeat steps a)-d) over and over during operation of the electrical machine.

10. The monitoring device (1) as claimed in claim 9, wherein the processing circuitry (5) is configured to compare the optimal weight parameter values with the initial weight parameter values or with the used weight parameter values, and to detect whether a change in electrical machine performance or an electrical machine fault has occurred based on the comparison result.

11. The monitoring device (1) as claimed in claim 10, wherein the detecting involves detecting a change in electrical machine performance or an electrical machine fault in case one of the optimal weight parameter values deviates by more than a predetermined amount from its corresponding initial weight parameter value or used weight parameter value.

12. The monitoring device (1) as claimed in claim 11, wherein the processing circuitry (5) is configured to determine a reason for the change in electrical machine performance or electrical machine fault based on the deviating optimal weight parameter value.

13. The monitoring device (1) as claimed in any of claims 9-12, wherein the weight parameter values are arranged in subsets forming respective correction matrices.

14. The monitoring device (1) as claimed in claim 13, wherein the thermal model (9) is a matrix equation including a thermal capacitance matrix, a thermal resistance matrix, and a power loss injection vector, wherein each of the thermal capacitance matrix, the thermal resistance matrix, and the power loss injection vector is multiplied with a respective one of the correction matrices.

15. The monitoring device (1) as claimed in any of claims 9-14, wherein the thermal model is a lumped-parameter thermal network, LPTN, model.

Fig. 1

Fig. 3

Fig. 2

Europäisches
Patentamt

European
Patent Office

Office européen
des brevets

# EUROPEAN SEARCH REPORT

Application Number

EP 20 18 0009

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | EP 1 959 532 A1 (ABB RESEARCH LTD [CH]) 20 August 2008 (2008-08-20)<br>* paragraphs [0001], [0013], [0035], [0046], [0047], [0067] - [0078], [0081]; figures 1,6,8 * | 1,5-9, 13-15<br>2-4, 10-12 | INV.<br>G05B19/418<br>G05B13/04<br>H02K11/25<br>H02H7/085 |
| A | EP 3 339 987 A1 (ABB AG [DE]) 27 June 2018 (2018-06-27)<br>* paragraphs [0011], [0027], [0030] * | 1-15 | |
| A | CN 111 274 669 A (UNIV BOHAI) 12 June 2020 (2020-06-12)<br>* the whole document * | 1-15 | |

TECHNICAL FIELDS SEARCHED (IPC)

G05B
H02K
H02H

The present search report has been drawn up for all claims

| Place of search | Date of completion of the search | Examiner |
|---|---|---|
| The Hague | 27 October 2020 | Salvador, Didier |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P04C01)

**EP 3 926 426 A1**

## ANNEX TO THE EUROPEAN SEARCH REPORT
## ON EUROPEAN PATENT APPLICATION NO.

EP 20 18 0009

This annex lists the patent family members relating to the patent documents cited in the above-mentioned European search report.
The members are as contained in the European Patent Office EDP file on
The European Patent Office is in no way liable for these particulars which are merely given for the purpose of information.

27-10-2020

| Patent document cited in search report | | | Publication date | Patent family member(s) | | | Publication date |
|---|---|---|---|---|---|---|---|
| EP 1959532 | | A1 | 20-08-2008 | NONE | | | |
| EP 3339987 | | A1 | 27-06-2018 | CN | 108241295 | A | 03-07-2018 |
| | | | | EP | 3339987 | A1 | 27-06-2018 |
| | | | | HK | 1251669 | A1 | 01-02-2019 |
| | | | | US | 2018180314 | A1 | 28-06-2018 |
| CN 111274669 | | A | 12-06-2020 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SCIASCERA et al.** Analytical Thermal Model for Fast Stator Winding Temperature Prediction. *IEEE Transactions on industrial electronics,* August 2017, vol. 64 (8